# EUROPEAN PATENT APPLICATION

(11) **EP 4 060 729 A1**
(43) Date of publication of application: **21.09.2022**
(21) Application number: 21895916.1
(22) Date of filing: 18.06.2021
(51) Int. Cl.: H01L 23/498

(54) **PACKAGE SUBSTRATE AND PACKAGE STRUCTURE**

(30) Priority: 21.01.2021 CN 202110082929
(71) Applicant: Changxin Memory Technologies, Inc., Hefei City, Anhui 230000 (CN)
(72) Inventor: LU, Zongzheng, Hefei City, Anhui 230000 (CN)
(74) Representative: Lavoix
(86) International application number: PCT/CN2021/100847
(87) International publication number: WO 2022/156133

(57) **Abstract**

The present application relates to a package substrate and a package structure. The package substrate includes: a first conductive layer, located on the top of a base and comprising power lines configured to supply power to chips and signal lines configured to provide signals to the chips; and, a second conductive layer, located on the bottom of the base and comprising first pads and local interconnection lines, the first pads being electrically connected to the signal lines, the plurality of associated first pads being electrically connected by the local interconnection lines.

## Description

### Cross-Reference to Related Applications

The present application claims the priority to the Chinese Patent Application 202110082929.3, titled "PACKAGE SUBSTRATE AND PACKAGE STRUCTURE", filed to China National Intellectual Property Administration on January 21, 2021, which is incorporated herein by reference in its entirety.

### Technical Field

The present application relates to the technical field of semiconductors, and in particular to a package substrate and a package structure.

### Background

Packaging plays an important role in chips for various integrated circuits. Package substrates for chip packaging have effects of placing, fixing and protecting chips and enhancing thermoelectric performance. Moreover, the package substrates are bridges for communication between chips and external circuits. The packaging technology also directly affects the performance of chips and the design and manufacturing of printed circuit boards (PCBs) connected thereto, so it is very important.

At present, in the design of some package substrates, a plurality of associated signal lines for providing signals to chips are connected by providing plating bars on the top of the base. This design occupies a large area on the top of the base, so the arrangement of power lines on the top of the base needs to avoid the plating bars. Thus, the power lines are usually long and thin, resulting in higher DC resistance and possibly leading to the problem that the DC voltage drop exceeds the standard.

### Summary

In accordance to various embodiments of the present application, a package substrate and a package structure are provided.

The present application provides a package substrate, applied to chip packaging, comprising:
power lines and signal lines, the power lines being configured to supply power to chips, and the signal lines being configured to provide signals to the chips; and
a second conductive layer, located on the bottom of the base and comprising first pads and local interconnection lines; the first pads being electrically connected to the signal lines correspondingly, a plurality of first pads being electrically connected by the local interconnection lines.

The package substrate and the package structure according to the present application have the following beneficial effects.

For the package substrate and the package structure according to the present application, the first pads on the bottom of the base are electrically connected to the signal lines on the top of the base. By connecting the associated first pads through the local interconnection lines, the plurality of associated signal lines are connected, so it is unnecessary to arrange plating bars on the top of the base.

### Brief Description of the Drawings

In order to explain the technical solutions in the embodiments of the present application or in the prior art more clearly, the drawings to be used for describing the embodiments or the prior art will be introduced simply. Apparently, the drawings to be described below are merely some embodiments of the present application, and a person of ordinary skill in the art may further obtain other drawings according to these drawings without paying any creative effort.
FIG. 1 is a schematic structure diagram of a package structure in an embodiment;
FIG. 2 is a sectional view of the package structure in an embodiment;
FIG. 3 is a schematic structure diagram of a package substrate from one perspective in an embodiment;
FIG. 4 is a schematic structure diagram of the package substrate from another perspective in an embodiment;
FIG. 5 is a partially planar structure diagram of a second conductive layer in an embodiment;
FIG. 6 is a partially sectional view of the package substrate in an embodiment; and
FIG. 7 is a planar structure diagram of a package substrate in the prior art;
in which:
100: matrix; 200: package substrate; 210: base; 220: first conductive layer; 221: power line; 222: signal line; 223: first solder joint; 224: second solder joint; 230: second conductive layer; 231: first pad; 232: local interconnection line; 2321: leading-in terminal; 2322: interconnection line; 233: second pad; 240: third conductive layer; 241: first connection line; 242: second connection line; third conductive layer; 250: first conductive plug; 260: second conductive plug; and, 300: lead.

### Detailed Description

In order to facilitate the understanding of the present application, the present application will be described more fully below with reference to the relevant drawings. The preferred embodiments of the present application are shown in the drawings. However, the present application may be implemented in many different forms and is not limited to the embodiments described herein. On the contrary, these embodiments are provided to make the disclosure of the present application more thorough and comprehensive.

Unless otherwise defined, all technical and scientific terms used herein have the same meanings as those commonly understood by those skilled in the art to which the present application belongs. The terms used in the specification of the present application are only for describing specific embodiments, rather than limiting the present application.

It should be understood that, when an element or layer is described as being "on", "adjacent to", "connected to" or "coupled to" other elements or layers, this element or layer may be directly on, adjacent to, connected to or coupled to other elements or layers, or there may be intervening elements or layers. On the contrary, when an element is described as being " directly on", "directly adjacent to", "directly connected to" or "directly coupled to" other elements or layers, there are no intervening elements or layers. It should be understood that, although various elements, components, regions, layers, doping types and/or portions are described by using terms such as first, second and third, these elements, components, regions, layers, doping types and/or portions shall not be limited by these terms. These terms are merely for distinguishing one element, component, region, layer, doping type or portion from another element, component, region, layer, doping type or portion. Therefore, without departing from the teaching of the present application, the first element, component, region, layer, doping type or portion discussed below may be denoted as a second element, component, region, layer or portion. For example, the first conductive plug may be replaced with a second conductive plug; and similarly, the second conductive plug may be replaced with a first conductive plug.

The terms indicating a spatial relationship, such as "under", "underneath", "lower", "below", "above" and "upper", can be used for describing a relationship between one element or feature shown in the drawings and other elements or features. It should be understood that, in addition to the orientation shown in the drawings, the terms indicating the spatial relationship further include different orientations of the device in use and operation. For example, if the device in the drawings is turned upside down, the element or feature described as being "underneath" or "below" other element will be oriented to be "above" the other element or feature. Therefore, the exemplary terms "underneath" and "below" may include up and down orientations. In addition, the device may also include additional orientations (e.g., rotated at 90 degrees or other orientations), and the spatial description used herein are interpreted correspondingly.

As used herein, the singular forms "a", "an" and "said/the" may include plural forms, unless the context clearly indicates otherwise. It should be further understood that, when the terms "consisting of" and/or "including/comprising" are used in the specification, the terms may specify the presence of the stated features, integers, steps, operations, elements and/or components, but do not exclude the presence or addition of one or more other features, integers, steps, operations, elements, components and/or combinations thereof. Meanwhile, as used herein, the term "and/or" includes any and all combinations of the related items listed.

In a circuit structure, only these wiring networks with high current are usually focused, but some wiring networks with very low current are ignored. However, it was found that, in some elongated wiring networks, due to high DC resistance, the problem that the DC voltage drop exceeds the standard may be caused even if the flowing current is very low.

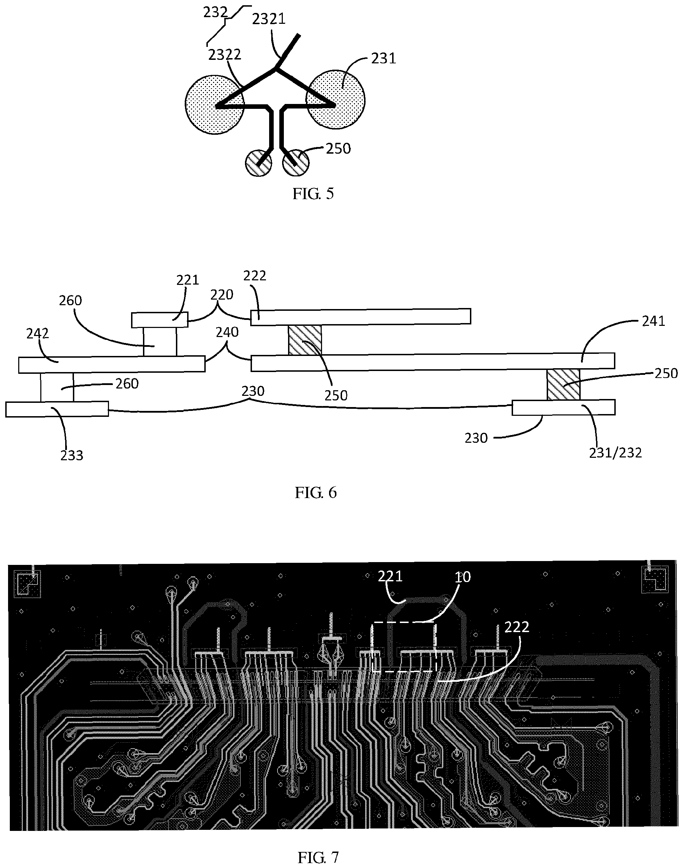

Referring to FIG. 7, as described in the background, in the design of some package substrates (e.g., in the design of low power double data rate (LPDDR) package substrates, a plurality of associated signal lines 22 are connected by arranging plating bars 10 on the top of the base of the package substrate. However, in this design, the power lines 221, which are also located on the top of the base, need to be arranged to avoid the plating bars 10. Thus, the power lines 221 on the package substrate are scattered to form an elongated network, possibly leading to the problem that the voltage drop exceeds the standard.

In view of this, the present application provides a package substrate and a package structure, which can avoid the problem that the DC voltage drop exceeds the standard.

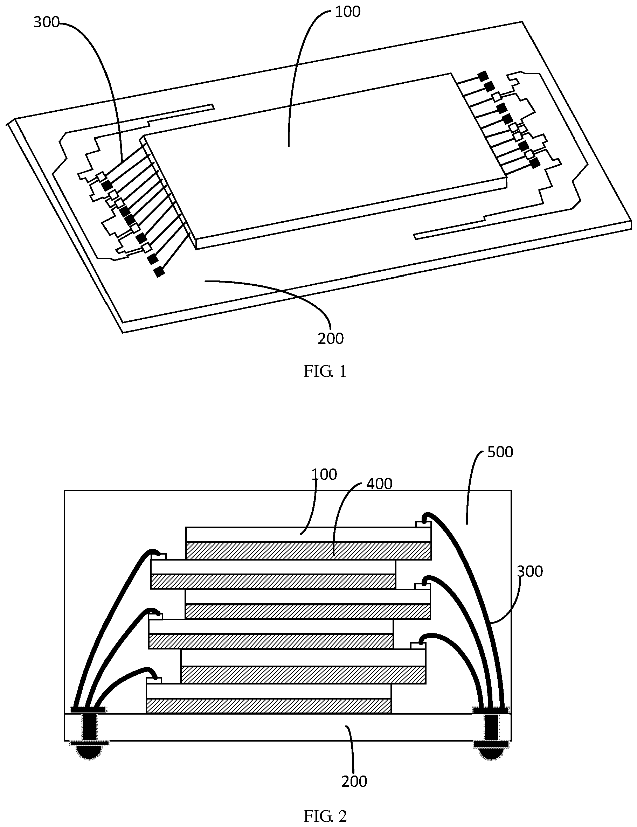

In one embodiment, referring to FIG. 1, a package structure is provided, the package structure comprises chips 100, a package substrate 200 and leads 300. The leads 300 may be metal wires, etc. One ends of the leads are connected to the chips 100, while the other ends of the leads are connected to the package substrate 200.

The chips 100 may be applied to chips for various integrated circuits. On the same package structure, there may be one or more chips 100.

As an example, referring to FIG. 2, when there are a plurality of chips 100, the plurality of chips 100 may be stacked in order to improve the integration density of the package structure.

In this case, the package structure may be arranged to further include adhesive film layers 400. Each of the adhesive film layers 400 connects two adjacent chips 100 or connects the package substrate 200 to the chip 100. Referring to FIG. 2, the package substrate 200 and the bottommost chip 200 are connected by the adhesive film layer 400, and two adjacent chips 100 are connected by a adhesive film layer 400.

Further, the plurality of chips may be stacked in a staggered manner, and two adjacent chips 100 are electrically connected to the package substrate 200 by the leads 300 on two opposite sides, respectively.

Specifically, referring to FIG. 2, on the package substrate 200, among the chips 100 arranged successively from the bottom up, the first chip, the second chip and the fifth chip are electrically connected to the package substrate 200 by the leads 300 on the left side of the chips, while the second chip, the fourth chip and the sixth chip are electrically connected to the package substrate 200 by the leads 300 on the right side of the chips.

In this case, the density of the leads can be effectively reduced, and the process difficulty of the leads can be reduced. Moreover, by reducing the density of the leads, the mutual interference among the leads can be effectively avoided, and the reliability of the package structure can be improved.

In addition, the package structure may further comprise a plastic package layer 500. The plastic package layer 500 covers the chips 100, so that the chips can be isolated from the outside, so as to prevent the impurities in the air from corroding the circuits of the chips and resulting in the degradation of the electrical performance of the chips. On the other hand, the chips packaged by the plastic package layer 500 are more convenient to mount and transport.

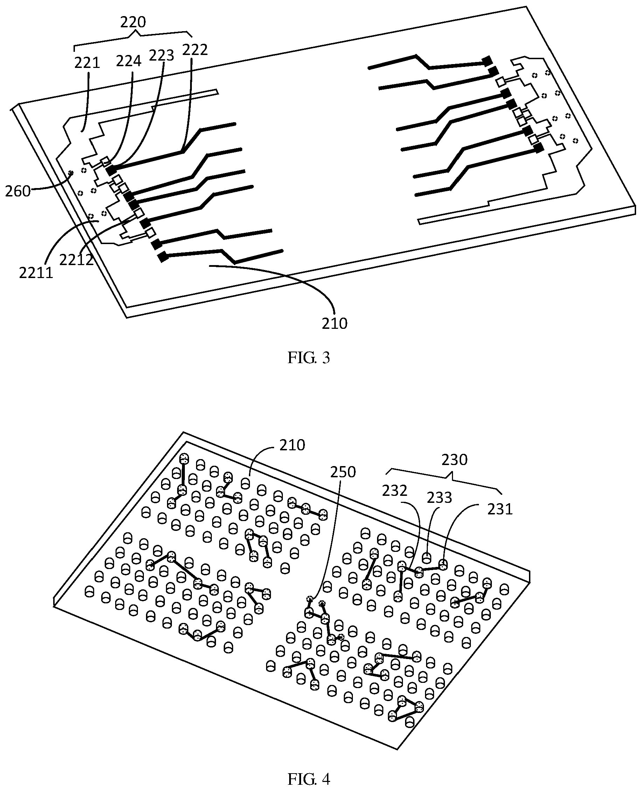

In one embodiment, referring to FIGS. 3 and 4, the package substrate 200 comprises a base 210, a first conductive layer 220 and a second conductive layer 230. The first conductive layer 220 is located on the top of the base 210. The second conductive layer 230 is located on the bottom of the base 210.

The first conductive layer 220 and the second conductive layer 230 may be, but not limited to, metal layers.

The first conductive layer 220 comprises power lines 221 and signal lines 222. The power lines 221 are configured to supply power to the chips 100. Specifically, the power lines 221 may comprise various types of power lines 221 for supplying power voltages such as VDDQ, VPP and VDD. The signal lines 222 are configured to provide signals to the chips 100. Specifically, the signal lines 222 may comprise various types of signal lines for transmitting signals such as DQ and DQS.

The second conductive layer 230 comprises first pads 231. First solder balls (not shown) may be formed on the first pads 231 to be electrically connected to an external circuit. The first solder balls may be, but not limited to, tin balls.

Meanwhile, the first pads 231 are electrically connected to the signal lines 222 correspondingly, so as to provide signals to the signal lines 222.

Meanwhile, in this embodiment, the second conductive layer 230 further comprises local interconnection lines 232. The local interconnection lines 232 connect a plurality of associated first pads 231.

Since the first pads 231 are electrically connected to the signal lines 222, the plurality of associated first pads 231 are connected, that is, the plurality of associated signal lines 222 can be connected.

It should be understood that, here, "a plurality of" means two or more. "A plurality of associated signal lines" means "a plurality of signal lines of a same type to be electrically connected together", and "a plurality of associated of first pads" means "a plurality of first pads electrically connected to a plurality of associated signal lines".

In this embodiment, by connecting the associated first pads 231 through the local interconnection lines 232, the plurality of associated signal lines 222 are connected, so it is unnecessary to arrange plating bars (i.e., plating bars 10) on the top of the base 210.

Thus, the space on the top of the base 210 can be greatly vacated, so that the wiring space is reserved for the power lines and it is unnecessary to detour the power lines. Therefore, in this embodiment, the line width of the power lines can be effectively expanded and the cross section can be effectively increased, so that the DC resistance impedance of the power lines is effectively reduced and the problem that the DC voltage drop exceeds the standard is effectively avoided.

In one embodiment, referring to FIG. 5, the first pads 231 are electrically connected to the corresponding signal lines 222 by the local interconnection lines 232. That is, one end of the local interconnection line 232 is electrically connected to the signal lines, while the other end the local interconnection line is electrically connected to the first pads 231, so that the electrical connection of the first pads 231 to the corresponding signal lines 222 is realized. In this case, it can be convenient for the flexible arrangement of the first pads 231.

Of course, the way of electrically connecting the first pads 231 to the signal lines 222 is not limited thereto. For example, the first pads 231 may also be directly connected to the signal lines 222 by corresponding conductive plugs.

In one embodiment, the second conductive layer 230 comprises a wiring layer and a pad layer. The local interconnection lines 232 is located in the wiring layer, and the first pads 231 are located in the pad layer. Moreover, the pad layer is formed on the wiring layer.

That is, in this embodiment, the local interconnection lines 232 and the first pads 231 are formed in different film layers. Moreover, the pad layer is formed prior to the wiring layer.

In this case, the local interconnection lines 232 and the first pads 231 can be formed by different processes according to the actual requirements for the local interconnection lines 232 and the first pads 231.

In this embodiment, since the local interconnection lines 232 formed below the first pads 231 connect a plurality of associated different first pads 231. Therefore, a portion of the local interconnection line is covered by the first pads 231, while a portion of the local interconnection line is not covered by the first pads 231.

A portion of the local interconnection line 232 not covered by the first pads 231 may have a bending angle. In this case, further, the bending angle may be set as an obtuse angle, so that the local interconnection line 232 is prevented from emitting signals at bending positions to affect the transmission of electrical signals.

As an example, the wiring layer may be formed by a electroplating process. In this case, still referring to FIG. 5, each local interconnection line 232 may comprise a leading-in terminal 2321 and at least two interconnection lines 2322 connected to the leading-in terminal 2321. In the electroplating process, an electroplating solution is introduced from the leading-in terminal 2321 and flows to the interconnection lines 2312, so that the local interconnection line 232 comprising the leading-in terminal 2321 and the interconnection lines 2322 is formed.

Of course, in this embodiment, the wiring layer is not necessarily formed by the electroplating process.

Alternatively, in some embodiments, the arrangement form of the second conductive layer 230 may not be limited to a form including a wiring layer and a pad layer.

For example, the local interconnection lines 232 and the first pads 231 may also be formed in a same conductive film layer. In this case, the first pads 231 may also be electrically connected to the corresponding signal lines 222 by the local interconnection lines 232. Of course, the first pads 231 may also be directly electrically connected to the corresponding signal lines 222 by corresponding conductive plugs.

Alternatively, the second conductive layer 230 may comprise more conductive functional film layers, and it will not be limited in the present application.

In one embodiment, still referring to FIG. 3, the first conductive layer 220 further comprises first solder joints 223 and second solder joints 224. Both the first solder joints 223 and the second solder joints 224 are electrically connected to the chips 100 by the leads 300.

Moreover, the first solder joints 223 are connected to the signal lines 222, so that the signal lines 222 provide signals to the chips. The second solder joints 224 are connected to the power lines 221, so that the power lines 221 supply power to the chips.

It should be understood that both the first solder joints 223 and the second solder joints 224 are conductive regions for being connected to the leads 300. Meanwhile, chip solder joints corresponding to the first solder joints 223 and the second solder joints 224 are also usually arranged on the chips 100 to realize the connection to the leads 300.

The leads 300 are usually connected to the chip solder joints on the chips and the first solder joints 223 or the second solder joints 223 by a wire bonding process.

The arrangement of the first solder joints 223 and the second solder joints 224 may be convenient for the connection to the leads 300. Of course, the arrangement form of the first conductive layer in the present application is not limited thereto.

For example, in some embodiments, since the power lines 221 have a large line width, the leads 300 may be directly connected to the power lines 221 without the second solder joints 224.

Alternatively, in the same embodiment, different leads 300 may also be electrically connected to the power lines in a different way. Specifically, it can be set that some of the leads 300 are connected to the second solder joints 224 to be electrically connected to the power lines 221 while some of the leads 300 are directly connected to the power lines 221.

In one embodiment, it can be set that the same power line 221 is connected to a plurality of second solder joints 224. In this case, on the top of the base 210, the power lines 221 of a same type to be connected to a plurality of second solder joints 224 may be formed into a complete plane, so that the impedance of the power lines 221 is further reduced, the structure of the first conductive layer 220 can be simplified, and it is convenient for processing.

In one embodiment, each of the power lines 221 comprises a line body 2211 and connection ports 2212. The connection ports 2212 connect the line body 2211 to the second solder joints 224.

In this embodiment, by dividing each of the power lines 221 into a line body 2211 and connection ports 2212, it is convenient to set a relatively large line width of the line body, and the DC impedance is reduced. Meanwhile, by arranging the connection ports 2212, it is convenient to arrange the first solder joints 223 and the second solder joints 224 in a row when the same power line 221 is connected to a plurality of second solder joints 224, so that it is convenient for processing.

In one embodiment, referring to FIG. 6, the package substrate 200 further comprises a third conductive layer 240 and first conductive plugs 250. The third conductive layer may be, but not limited to, a metal layer.

The third conductive layer 240 is located between the first conductive layer 220 and the second conductive layer 230.

Moreover, the third conductive layer 240 comprises first connection lines 241. The first connection lines 241 are electrically connected to the signal lines 222 and the first pads 231 by the first conductive plugs 250, respectively, so that the signal lines 222 are electrically connected to the corresponding first pads 231.

Specifically, for the same first connection line 241, one end of the first connection line is electrically connected to the signal line 222 by the first conductive plug 250 between the first conductive layer 220 and the third conductive layer 240, and the other end of the first connection line is electrically connected to the first pad 231 by the first conductive plug 250 between the second conductive layer 230 and the third conductive layer 240.

In this embodiment, by arranging the third conductive layer 240, the first pads 231 connected to the signal lines 222 can be arranged freely and flexibly without being affected by the positions of the signal lines 222.

When the first pads 231 are electrically connected to the corresponding signal lines 222 by the local interconnection lines 232, more specifically, for the same first connection line 241, one end thereof is electrically connected to the signal line 222 by the first conductive plug 250 between the first conductive layer 220 and the third conductive layer 240, and the other end thereof is electrically connected to the local interconnection line 232 by the first conductive plug 250 between the second conductive layer 230 and the third conductive layer 240 (also referring to FIG. 5), so that the electrical connection to the first pad 231 is realized.

Of course, the present application is not limited thereto. In some embodiments, it is also possible that the third conductive layer 240 is not provided. In this case, the signal lines 222 may be directly connected to the corresponding first pads 231 by the first conductive plugs 250.

In one embodiment, referring to FIG. 4, the second conductive layer 230 further comprises second pads 233. Second solder balls (not shown) may be formed on the second pads 233 to be electrically connected to an external circuit. The second solder balls may be, but not limited to, tin balls, and may be formed in the same procedure as the first solder balls.

Meanwhile, the second pads 233 are electrically connected to the power lines 221 corresponding so as to supply power to the power lines 221.

When the second conductive layer 230 comprises a wiring layer and a pad layer, it can be set that both the second pads 233 and the first pads 231 are located in the pad layer (that is, the both may be formed in the same layer) and the local interconnection lines 232 are located in the wiring layer.

Further, the package substrate may further comprise second conductive plugs 260, so that the second pads 233 may be electrically connected to the power lines 221 by the second conductive plugs 260 conveniently.

In one embodiment, referring to FIG. 6, the package substrate comprises a third conductive layer 240 which is located between the first conductive layer 220 and the second conductive layer 230.

Moreover, the third conductive layer 240 comprises second connection lines 242. The second connection lines 242 are electrically connected to the power lines 221 and the second pads 233 by the second conductive plugs 260, respectively.

Specifically, for the same second connection line 242, one end thereof is electrically connected to the power line 221 by the second conductive plug 260 between the first conductive layer 220 and the third conductive layer 240, and the other end thereof is electrically connected to the second pad 233 by the second conductive plug 260 between the second conductive layer 230 and the third conductive layer 240.

Here, for the electrical connection the other end of the second connection line 242 to the second pad 233 by the second conductive plug 260 between the second conductive layer 230 and the third conductive layer 240, the second conductive plug 260 may be directly connected to the second pad 233, or the second conductive plug 260 may be connected to the second pad 233 by another conductive structure. It will not be limited in the present application.

In this embodiment, by arranging the third conductive layer 240, the second pads 233 connected to the power lines 221 can be arranged freely and flexibly without being affected by the positions of the power lines 221.

In this case, further, it can be set that the first pads 231 and the second pads 233 are arranged in arrays on the bottom of the base 210, so that the space on the bottom of the base 210 can be effectively utilized and the reliability of the package substrate can be improved.

Here, specifically, referring to FIG. 4, the first pads 231 and the second pads 233 may be arranged in multiple arrays (e.g., four arrays in FIG. 4) on the bottom of the base 210. Moreover, the local interconnection lines 232 may be arranged in the blank regions between multiple arrays, so that the arrangement space for the local interconnection lines 232 is larger and the local interconnection lines 232 can be arranged in the second conductive layer 230 more freely and flexibly.

In this case, if the first conductive plugs 250 electrically connecting the signal lines 222 to the first pads 231 are connected to the local interconnection lines 232, some of the first conductive plugs 250 connected to the local interconnection lines 232 may also be arranged in the black region between arrays, so that it is convenient for the layout and arrangement of the first conductive plugs 250.

Specifically, in this case, it is possible that both the first connection lines 241 and second connection lines 242 are arranged in the third conductive layer 240. The first connection lines 241 are electrically connected to the signal lines 222 and the first pads 231 by the first conductive plugs 250, respectively. The second connection lines 242 are electrically connected to the power lines 221 and the second pads 233 by the second conductive plugs 260, respectively, so that the first pads 231 and the second pads 233 are arranged in arrays on the bottom of the base 210.

In one embodiment, referring to FIG. 2, since a sufficient arrangement space is provided for the arrangement of the power lines 221 on the top of the base 210, by setting the same power line 221 to be connected to a plurality of second conductive plugs 260, the connecting via region can be effectively increased, better backflow can be realized, and the DC voltage drop can be reduced.

As an example, a plurality of second conductive plugs 260 may be arranged in both the length direction and width direction of the power line 221, so that better backflow can be realized, and the DC voltage drop can be further reduced.

As an example, when the package substrate comprises a third conductive layer 240, the same power line 221 may be connected to the second connection lines 242 of the third conductive layer 240 by a plurality of second conductive plugs 260. As an example, when the package substrate comprises no third conductive layer 240, the same power line 221 may be connected to a plurality of second pads 233 of the second conductive layer 230 by a plurality of second conductive plugs 260.

In sum, for the package substrate and the package structure according to the present application, the first pads on the bottom of the base are electrically connected to the signal lines on the top of the base. By connecting the associated first pads by the local interconnection lines, the plurality of associated signal lines are connected, so it is unnecessary to arrange plating bars on the top of the base.

Thus, the space on the top of the base is greatly vacated, so that the wiring space is reserved for the power lines and it is unnecessary to detour the power lines. Therefore, according to the present application, the line width of the power lines can be effectively expanded and the cross section can be effectively increased, so that the DC resistance impedance of the power lines is effectively reduced and the problem that the DC voltage drop exceeds the standard is effectively avoided.

Various technical features of the above embodiments can be arbitrarily combined. For simplicity, not all possible combinations of various technical features of the above embodiments have been described. However, all combinations of these technical features shall be included in the scope recorded by the specification if not conflicted.

The above embodiments merely show several implementations of the present application, and the description thereof is specific and detailed relatively but cannot be interpreted as limiting the patent scope of the present application. It should be noted that, for a person of ordinary skill in the art, several variations and improvements can be made without departing from the concept of the present application, and all the variations and improvements shall fall into the protection scope of the present application. Therefore, the protection scope of the present application should be subject to the appended claims.

## Claims

1. A package substrate, applied to chip packaging, comprising:
a first conductive layer, located on the top of a base and comprising power lines and signal lines; the power lines being configured to supply power to chips, the signal lines being configured to provide signals to the chips; and
a second conductive layer, located on the bottom of the base and comprising first pads and local interconnection lines; the first pads being electrically connected to the signal lines correspondingly, a plurality of associated first pads being electrically connected by the local interconnection lines.

2. The package substrate according to claim 1, wherein the first pads are electrically connected to the corresponding signal lines by the local interconnection lines.

3. The package substrate according to claim 2, wherein the second conductive layer comprises a wiring layer and a pad layer; the local interconnection lines are located in the wiring layer; the first pads are located in the pad layer; the pad layer is formed on the wiring layer; and, a portion of the local interconnection line not covered by the first pads has a bending angle, the bending angle is an obtuse angle.

4. The package substrate according to claim 1, wherein the first conductive layer further comprises first solder joints and second solder joints; both the first solder joints and the second solder joints are used for electrical connection to the chips; the signal lines are connected to the first solder joints; and, the power lines are connected to the second solder joints.

5. The package substrate according to claim 4, wherein the same power line is connected to a plurality of second solder joints.

6. The package substrate according to claim 5, wherein each of the power lines comprises a line body and connection ports, and the connection ports connect the line body to the second solder points.

7. The package substrate according to claim 1, further comprising a third conductive layer and first conductive plugs, the third conductive layer being located between the first conductive layer and the second conductive layer, and the third conductive layer comprising first connection lines, the first connection lines being electrically connected to the signal lines and the first pads by the first conductive plugs, respectively.

8. The package substrate according to claim 1, wherein the second conductive layer further comprises second pads, the second pads are electrically connected to the power lines correspondingly.

9. The package substrate according to claim 8, further comprising second conductive plugs, the second pads being electrically connected to the power lines by the second conductive plugs.

10. The package substrate according to claim 9, further comprising a third conductive layer, the third conductive layer being located between the first conductive layer and the second conductive layer, and the third conductive layer comprising second connection lines; the second connection lined being electrically connected to the power lines and the second pads by the second conductive plugs, respectively.

11. The package substrate according to claim 9, wherein the same power line is connected to a plurality of second conductive plugs.

12. The package substrate according to claim 11, wherein a plurality of second conductive plugs are arranged in a length direction and a width direction of the power line.

13. The package substrate according to claim 10, wherein the first pads and the second pads are arranged in arrays on the bottom of the base.

14. A package structure, comprising chips, leads and the package substrate according to claim 1, one ends of the leads being connected to the chips while the other ends of the lead being connected to the package substrate.

15. The package structure according to claim 14, wherein there are a plurality of chips, the plurality of chips are stacked; and the package structure further comprises adhesive film layers, each of the adhesive film layers connects two adjacent chips or connects the package substrate to the chip.

16. The package structure according to claim 15, wherein the plurality of chips are stacked in a staggered manner, and two adjacent chips are electrically connected to the package substrate by the leads on two opposite sides, respectively.

17. The package structure according to claim 14, further comprising a plastic package layer covering the chips.
